# EUROPÄISCHE PATENTSCHRIFT

(11) **EP 4 715 408 B1**
(45) Veröffentlichungstag und Bekanntmachung des Hinweises auf die Patenterteilung: **11.11.2026**
(21) Anmeldenummer: 24201560.0
(22) Anmeldetag: 20.09.2024
(51) Int. Cl.: G01R 31/389, G01R 31/396

(54) **VERFAHREN UND VORRICHTUNG ZUR STROMANREGUNG FÜR DIE IMPEDANZMESSUNG**
METHOD AND APPARATUS FOR GENERATING CURRENT FOR IMPEDANCE MEASUREMENT
PROCÉDÉ ET DISPOSITIF D'EXCITATION DE COURANT POUR LA MESURE D'IMPÉDANCE

(43) Veröffentlichungstag der Anmeldung: 25.03.2026
(73) Patentinhaber: Safion GmbH, 52068 Aachen (DE)
(72) Erfinder: Wienhausen, Arne Hendrik, 52070 Aachen (DE)
(74) Vertreter: Raffay & Fleck

(56) Entgegenhaltungen:
- CN-A- 117 289 161
- CN-A- 118 191 643
- CN-A- 118 376 932
- US-A1- 2023 105 040
- US-B2- 10 386 422
- US-B2- 10 566 817
- KOCH REINHOLD: "On-line Electrochemical Impedance Spectroscopy for Lithium-Ion Battery Systems Estimation, Compensation and Avoidance of Measurement Deviations", 1 December 2017 (2017-12-01), Munich, Germany, pages 1 - 249, XP093256902, Retrieved from the Internet <URL:https://mediatum.ub.tum.de/doc/1343447/1343447.pdf> [retrieved on 20250306]
- ISLAM S M RAKIUL ET AL: "Precise Online Electrochemical Impedance Spectroscopy Strategies for Li-Ion Batteries", IEEE TRANSACTIONS ON INDUSTRY APPLICATIONS, IEEE SERVICE CENTER, PISCATAWAY, NJ, US, vol. 56, no. 2, 9 December 2019 (2019-12-09), pages 1661 - 1669, XP011778171, ISSN: 0093-9994, [retrieved on 20200312], DOI: 10.1109/TIA.2019.2958555
- XIE NING ET AL: "A Method for Measuring Electrochemical Impedance Spectroscopy in High-voltage Battery Systems", 2024 INTERNATIONAL CONFERENCE ON ENERGY AND ELECTRICAL ENGINEERING (EEE), IEEE, 5 July 2024 (2024-07-05), pages 1 - 5, XP034727207, DOI: 10.1109/EEE59956.2024.10709725
- ABEDI VARNOSFADERANI MINA ET AL: "A Comparison of Online Electrochemical Spectroscopy Impedance Estimation of Batteries", IEEE ACCESS, vol. 6, 16 May 2018 (2018-05-16), pages 23668 - 23677, XP011683703, DOI: 10.1109/ACCESS.2018.2808412
- JABBOUR NIKOLAOS ET AL: "Real-Time Estimation of the Lithium-ion Battery Impedance in Electric Vehicles utilizing the Electrochemical Impedance Spectroscopy Technique", 2023 3RD INTERNATIONAL CONFERENCE ON ELECTRICAL, COMPUTER, COMMUNICATIONS AND MECHATRONICS ENGINEERING (ICECCME), IEEE, 19 July 2023 (2023-07-19), pages 1 - 6, XP034428696, DOI: 10.1109/ICECCME57830.2023.10252321

## Beschreibung

Die vorliegende Schrift betrifft ein Verfahren und eine Vorrichtung zur Impedanzmessung (EIS-Messung) eines Akkumulators.

Derartiges ist zahlreich aus dem Stand der Technik bekannt, wie beispielsweise aus "On-line Electrochemical Impedance Spectroscopy for Lithium-Ion Battery Systems Estimation, Compensation and Avoidance of Measurement Deviations" Koch, Reinhold oder der US 10,386,422 B2 oder US 10,566,817 B2.

Auch ist eine Vorrichtung, bei der Ladungen zwischen Halbzellen verschoben werden, aus der WO 2021/175,623 A1 bekannt. Dieses Verfahren ist aber nicht anwendbar, wenn nur Plus- und Minuspol des Akkumulators mit ausreichendem Leitungsquerschnitt verfügbar sind.

Zudem werden Innenwiderstände und Impedanzen von üblichen Akkumulatoren, insbesondere mit großen Leistungen zunehmend kleiner, was übliche Vorrichtungen insbesondere während der Ladung- und Entladung aber auch bei EMV-Einflüssen aus der Umgebung vor große Schwierigkeiten stellen.

Bekannte Vorrichtungen und Verfahren bringen in solchen Fällen die Nachteile mit sich, dass nur asymmetrische Spannungen bezüglich der Batteriespannung bereitgestellt werden, sodass die Spannung über der Induktivität über Schaltzustände betragsmäßig ungleich ist und dadurch der Headroom klein und unsymmetrisch ist. Dies führt dazu, dass der (minimale bzw. maximale) Tastgrad der einzelnen Halbleiter, der sich über die Periode des angeregten Stroms ändert, sehr klein oder sehr groß gewählt werden muss und zu einer schlechten Ausnutzung der Halbleiter oder zu sehr deutlich von sinusförmigen Anregungen abweichenden Anregungen führt, insbesondere weil die nötige Stromsteilheit nicht erreicht werden kann. Dies ist insbesondere für hohe Akkumulatorspannungen problematisch. Auch muss, um Symmetrie herzustellen, eine zur Akkumulatorspannung doppelt so hohe Versorgungsspannung verwendet werden, was zu hohen Bauteilkosten und hohem apparativen Aufwand führt, insbesondere wenn Geräte dadurch der Mittelspannungs-Norm unterfallen, was beispielsweise bei 800-V-Batterien der Fall ist.

Klassische Systeme arbeiten mit linearen Ausgangsstufen, wodurch nur ein geringer Wirkungsgrad erreicht werden kann, da die gesamte Spannung, die wir als Headroom bezeichnen (positive Versorgungsspannung der Ausgangsstufe - Batteriespannung, bzw. Batteriespannung - negative Versorgungsspannung der Ausgangsstufe) vollständig über die Ausgangstransistoren abfallen muss und entsprechende Verluste erzeugt. Mit linearen Lösungen ist es schwierig, hohe Ströme zu stellen. So sind große Kühlvorrichtungen notwendig und man benötigt sehr viel größere Netzteile, Filter, usw. außerdem ist es sehr energieintensiv.

Mit geschalteten Endstufen (vgl. Klasse-D-Verstärker) ist der Wirkungsgrad signifikant höher und ist es möglich, Energie während der negativen Halbwelle im Zwischenkreis kurzzeitig zu speichern und während der positiven Halbwelle wieder zu verwenden. In einer anderen Ausführung ist es auch vorteilhaft eine bidirektionale Spannungsquelle zu nutzen, um die Energie zurückzuführen.

Mit einer Brückenschaltung mit Filterdrossel (Buck-Wandler) benötigt man allerdings einen gewissen Headroom, um in einer gewissen Zeit einen gewissen Strom auf- oder abmagnetisieren zu können (di/dt = v_L / L). Das notwendige di/dt lässt sich aus dem geforderten Anregungssignal ableiten. Dabei ist grundsätzlich ein positiver oder oberer Headroom und ein unterer oder negativer Headroom zu unterscheiden. Bei klassischen Anordnungen ist ihre Summe konstant durch die Speisespannung bestimmt und wird ihre Aufteilung durch die Spannung des elektrochemischen Elements bestimmt. Dabei ist ein Headroom gleich der Spannung des elektromagnetischen Elements und der andere gleich der Speisespannung abzüglich der des elektrochemischen Elements.

Wählt man einen Headroom zu klein oder die Induktivität der Drossel zu groß, ist es physikalisch nicht möglich, eine ausreichende Stromsteilheit zu erreichen. In der Realität kommen Leitungs- und Übergangswiderstände hinzu, welche einen bei hohen Strömen nicht zu vernachlässigenden Spannungsabfall verursachen, wodurch die Spannung über der Drossel reduziert wird. Somit muss der Headroom stets groß genug sein, um auch bei hohen Strömen eine hohe Stromsteilheit zu erreichen.

Zudem ist es generell sehr schwierig, mit geschalteten Endstufen hohe Bandbreiten, bei hohem Strom zu erzielen, da man dazu sehr hohe Schaltfrequenzen benötigt oder mehrere parallele Phasen. Dazu braucht man entsprechende Bauteile und entsprechende Rechenleistung und Ansteuerung.

Es ist Aufgabe der Erfindung eine performantere Erzeugung des Anregungsstroms bereit zu stellen, die insbesondere mit vergleichsweise einfacher Hardware und vergleichsweise geringer Verlustleistungen hohe Bandbreiten erreichen kann.

Dies wird gelöst durch eine Vorrichtung nach Anspruch 1, ein Verfahren nach Anspruch 11 und eine Verwendung nach Anspruch 14.

Die erfindungsgemäße Lösung bietet dabei die Vorteile, dass, insbesondere symmetrische, Spannungen um die Akkumulatorspannung bereitgestellt werden können, mittels DC-DC-Wandler galvanisch gekoppelt oder getrennt gearbeitet werden kann und die Spannung über der Speicher-Induktivität der Halbbrücke über den Betrieb gemittelt betragsmäßig ähnlich gehalten werden und symmetrische Headrooms erreicht werden können, was zu einer gleichmäßigeren und damit besseren Ausnutzung der Halbleiter führt. Dadurch lassen sich höhere Dynamiken (höhere Bandbreite) ermöglichen, kann die Verlustleistung auf die Halbleiter gleichmäßiger oder sogar symmetrischer verteilt werden und somit kann eine effizientere Kühlung ermöglicht werden. Zudem muss die Spannung der Eingangsspannungsversorgung, also die Versorgung der Spannungsquelle verglichen mit der Akkumulatorspannung weniger als doppelt so hoch sein, um symmetrische Spannungen für die Ausgangsbrücke zu erhalten.

Betrachtet man ein 12,8-V-Element aus vier in Reihe geschalteten 3,2-V-Akkumulatorzellen und arbeitet man klassisch mit einer 15V Versorgungsspannung erreicht man nur 15V -12,8V = 2,2 V positiven Headroom und (-) 12,8V negativen Headroom. Wünscht man aber einen negativen wie positiven 10 V Headroom, würden sich +2,8 V und +22,8 V ergeben (unipolar), bei je 20 V Headroom ergeben sich -7,2 V und 32,8 V (bipolar). Bei einer klassischen Anordnung und 40V Versorgungsspannung ergeben sich nur (-) 12,8 V und anderseits 27,2 V Headroom.

Gelöst wird die Aufgabe durch ein Verfahren zur Anregung mindestens eines Stroms durch ein elektrochemisches Element, insbesondere aufweisend eine Mehrzahl zwischen einem ersten Pol und einem zweiten Pol in Reihe geschalteter Zellen, insbesondere zur Durchführung mindestens einer Impedanzmessung, insbesondere elektrochemischer Impedanzspektroskopie, insbesondere umfassend die Bestimmung mindestens eines Impedanzwertes, insbesondere einer Vielzahl von Impedanzwerten, des Elements.

Die Anregung des mindestens eines Stroms erfolgt mittels über die Zeit veränderter Ansteuerung mindestens zweier Schaltelemente mindestens einer Halbbrücke. Dabei erfolgt die Spannungsversorgung der Halbbrücke gleichzeitig durch eine erste und eine zweite Spannung, die verschieden und beide ungleich des Potentials eines Pols, insbesondere ungleich der Potentiale beider Pole, des elektrochemischen Elements sind.

Gelöst wird die Aufgabe auch durch eine Verwendung zweier Spannungen zur gleichzeitigen Speisung einer Halbbrücke zur Anregung mindestens eines Stroms durch ein elektrochemisches Element mit mindestens zwei Polen, insbesondere aufweisend eine Mehrzahl zwischen einem ersten Pol und einem zweiten Pol in Reihe geschalteter Zellen, insbesondere zur Durchführung mindestens einer Impedanzmessung, insbesondere elektrochemischer Impedanzspektroskopie, insbesondere umfassend die Bestimmung mindestens eines Impedanzwertes, insbesondere einer Vielzahl von Impedanzwerten, des Elements,
wobei die Anregung des mindestens eines Stroms mittels über die Zeit veränderter Ansteuerung mindestens zweier Schaltelemente der Halbbrücke erfolgt,
dadurch gekennzeichnet, dass die Spannungen verschieden und ungleich des Potential eines Pols, insbesondere ungleich der Potentiale beider Pole, des elektrochemischen Elements sind.

Ebenso wird die Aufgabe gelöst durch eine Vorrichtung zur Anregung mindestens eines Stroms durch ein elektrochemisches Element, insbesondere aufweisend eine Mehrzahl zwischen einem ersten Pol und einem zweiten Pol in Reihe geschalteter Zellen, insbesondere zur Durchführung mindestens einer Impedanzmessung, insbesondere elektrochemischer Impedanzspektroskopie, insbesondere eingerichtet zur Bestimmung mindestens eines Impedanzwertes, insbesondere einer Vielzahl von Impedanzwerten, des Elements,
wobei die Vorrichtung einen ersten Anschluss zum Anschluss eines ersten Pols des zu vermessenden Elements und einen zweiten Anschluss zum Anschluss eines zweiten Pols des zu vermessenden Elements aufweist, wobei die Vorrichtung mindestens eine Halbbrücke mit zwei Schaltelementen aufweist, deren erstes Schaltelement zwischen einem ersten Versorgungsleiter und dem ersten Anschluss und deren zweites Schaltelement zwischen dem ersten Anschluss und einem zweiten Versorgungsleiter angeordnet ist (wobei die Anordnung unmittelbar am ersten Anschluss und/oder am zweiten Versorgungsleiter erfolgen kann aber nicht muss, es können weitere Elemente zwischengeschaltet sein, wie mindestens eine Drossel und/oder mindestens ein Filter), wobei die Vorrichtung eingerichtet ist, zwecks Anregung des mindestens einen Stroms die Schaltelemente der mindestens einen Halbbrücke über die Zeit verändert anzusteuern und wobei die Vorrichtung eine, insbesondere bidirektionale, Spannungsquelle aufweist, die eine erste Spannung ungleich null gegen den zweiten Anschluss auf dem ersten Versorgungsleiter und eine zweite, insbesondere umgekehrt gepolte, Spannung ungleich der ersten Spannung gegen den zweiten Anschluss und insbesondere ungleich null gegen den zweiten Anschluss, auf dem zweiten Versorgungsleiter bereit stellt.

Gelöst wird die Aufgabe weitergehend auch durch eine Vorrichtung zur Impedanzmessung aufweisend eine erfindungsgemäße Vorrichtung zur Anregung und eine Vorrichtung zur Impedanzmessung aufweisend einen ersten Messleiter und einen zweiten Messleiter zum Anschließen an ein, insbesondere das, elektrochemische(s) Element zur Messung der Impedanz bei durch das elektrochemische Element fließendem sich über die Zeit veränderndem, insbesondere durch die Vorrichtung zur Anregung angeregtem, Strom. Weist das elektrochemische Element mindestens zwei in Reihe geschaltete elektrochemischen Zellen auf, werden insbesondere mindestens ein Messleiter mehr als die, insbesondere das doppelte der, Anzahl der in Reihe geschalteten elektrochemischen Zellen auf. Dabei werden insbesondere bei zusätzlicher Parallelschaltung von elektrochemischen Zellen nur die Stufen der Reihenschaltung gezählt.

Gelöst wird die Aufgabe weitergehend auch durch eine Anordnung bestehend aus einer Vorrichtung zur Anregung oder eine Vorrichtung zur Impedanzmessung, wobei das elektrochemische Element mit seinem ersten Pol mit dem ersten Anschluss und insbesondere auch erstem Messleiter und mit seinem zweiten Pol mit dem zweiten Anschluss und insbesondere auch zweitem Messleiter verbunden ist.

Die Erfindung kann auch bei elektrochemischen Elementen mit parallel und/oder in Reihe geschalteten elektrochemischen Zellen angewandt werden.

Mit besonderem Vorteil weist die Vorrichtung und/oder nutzt das Verfahren bzw. die Verwendung eine Mehrzahl erfindungsgemäßer Halbbrücken. Dabei können die Halbbrücken mit einer gemeinsamen Spannungsquelle oder mit einer Mehrzahl und/oder separaten Spannungsquellen gespeist werden.

Mit Vorteil wird das Verfahren mittels einer erfindungsgemäßen Vorrichtung ausgeführt, beinhaltet die Verwendung die Verwendung einer erfindungsgemäßen Vorrichtung und/oder ist die Vorrichtung zur Durchführung eines erfindungsgemäßen Verfahrens eingerichtet. Dazu weist sie insbesondere eine entsprechend eingerichtete Steuerungsvorrichtung auf.

Aus dem Stand der Technik ist es bekannt die Schaltelemente einer Halbbrücke zur Anregung eines Stroms durch Tastung der Schaltelemente mit über die Zeit (auch innerhalb einer Periode des anzuregenden Stroms) veränderlichen Tastgraden/Aussteuergraden zu betreiben und dadurch beispielsweise annähernd sinusförmige Ströme zu erzeugen. Dazu kann beispielsweise die Pulsweitenmodulation und/oder Pulsdichtemodulation verwendet werden. Dies kann mit der Erfindung ebenso erfolgen.

Elektrochemische Elemente kommen zahlreiche in Frage, klassische Akkumulatoren genauso wie beispielsweise Brennstoffzellen. Das Element kann dabei aus mehreren, insbesondere zumindest teilweise in Reihe geschalteter, insbesondere identischer, elektrochemischen Zellen gebildet sein. Eine Zelle kann beispielsweise eine Akkumulatorzelle oder eine Brennstoffzelle sein.

Die Pole des elektrochemischen Elements können durch eine Anode und eine Kathode gebildet sein.

Die Schaltelemente sind in der Regel steuerbare Zweipole der Halbbrücke, die insbesondere mittels einer digitalen Schaltanordnung gesteuert/geschaltet werden.

Mit Vorteil ist/wird die Spannungsquelle insbesondere mittels einer bidirektionalen Spannungsquelle und/oder zwei DC/DC-Konverter realisiert, die insbesondere zur Speisung mit einer unipolaren Eingangsspannungsversorgung verbindbar und/oder verbunden sind. Dadurch lässt sich sehr effizient die notwendige Versorgung bereitstellen.

Vorteilhafterweise ist/wird zwischen erstem Versorgungsleiter und dem zweiten Anschluss und zwischen zweitem Versorgungsleiter und dem zweiten Anschluss jeweils mindestens ein Kondensator angeordnet und/oder zwischen der Halbbrücke und erstem Anschluss und/oder zwischen zweitem und erstem Anschluss ein Filter und/oder eine Drossel angeordnet. Dadurch lässt sich eine geglättete Anregung erreichen.

Optimalerweise werden die erste und/oder die zweite Spannungsdifferenzen (erster und/oder zweiter Headroom) so gewählt, dass die gleiche mittlere Verlustleistung an beiden Schaltelementen anfällt und/oder die mögliche Dynamik maximiert wird. Theoretisch ist dies bei betragsmäßig gleichen Spannungsdifferenzen gegeben. Allerding führen Beschränkungen beispielsweise des maximalen oder minimalen Tastgrades eines oder beider Schaltelemente in manchen Ausführungen zu limitierenden Randbedingungen, sodass von einer symmetrischen Ausgestaltung zur Optimierung der Verlustleistungsverteilung auf beide Schaltelemente und/oder Maximierung der möglichen Dynamik abweichende Spannungsdifferenzen zu wählen sind. Auch beim Einsatz einer Vorrichtung für elektrochemische Elemente mit unterschiedlichen Nennspannungen oder Spannungen, kann nur eine Optimierung über den Anwendungsbereich stattfinden, die in einzelnen Fällen zu einer Abweichung vom Optimum führen muss. Dennoch bietet die erfindungsgemäße Lösung auch in diesen Fällen deutliche Vorteile gegenüber dem Stand der Technik.

Betrachtet man beispielsweise den Fall, dass die Schaltelemente eine Mindesttastlänge von mindestens 5 % der Periodendauer und nur mit einen maximalen Tastgrad von 85 % verwendet werden könne. Dann ergibt sich ein nutzbarer Bereich von 5 % bis 85 %. Es wäre daher vorteilhaft, den "Ruhe-Tastgrad" (dO) nicht auf 50 % festzulegen, sondern auf 45 % damit er in der Mitte des nutzbaren Bereichs liegt und sich ein symmetrischer Bereich zum Auf- und Abmagnetisieren ergibt. Damit wäre der Headroom aber auch nicht mehr symmetrisch und es müsste optimalerweise folgende Gleichung erfüllt sein: ${v}_{n} + \left({v}_{p}-{v}_{n}\right) ⋅ {d}_{0} = {v}_{out , 0} = {v}_{bat}$ mit ${d}_{0} = \frac{{d}_{min} + {d}_{max}}{2}$ und ${v}_{p} - {v}_{n} = {v}_{hr , p} + {v}_{hr , n}$

Mit
- *v_{hr,p}*: als positivem Headroom und
- *v_{hr,n}*: als negativem Headroom
und
vₒᵤₜ = v_{bat} = v_{out,0} als der Spannung des elektrochemischen Elements ergibt sich dann ${{{v}_{bat} - {v}_{hr , n}}_{︸}}_{= {v}_{n}} + {{\left({v}_{hr , p}+{v}_{hr , n}\right)}_{︸}}_{= {v}_{p} - {v}_{n}} ⋅ {d}_{0} = {v}_{bat}$ $- {v}_{hr , n} + \left({v}_{hr , p}+{v}_{hr , n}\right) ⋅ {d}_{0} = 0$ ${d}_{0} ⋅ {v}_{hr , p} + \left({d}_{0}-1\right) ⋅ {v}_{hr , n} = 0$ ${v}_{hr , p} = \frac{1 - {d}_{0}}{{d}_{0}} ⋅ {v}_{hr , n} = \left(\frac{1}{{d}_{0}}-1\right) ⋅ {v}_{hr , n} = \left(\frac{2}{{d}_{min} + {d}_{max}}-1\right) ⋅ {v}_{hr , n}$ ${v}_{hr , p} = \left(\frac{2}{{d}_{min} + {d}_{max}}-1\right) ⋅ {v}_{hr , n} = \left(\frac{2}{0 , 05 + 0 , 85}-1\right) ⋅ {v}_{hr , n} = 1 , 222 ⋅ {v}_{hr , n}$

Bevorzugt ist/wird eine erste Spannungsdifferenz (erster Headroom) zwischen erster Spannung und erstem Anschluss, insbesondere Spannung des elektrochemischen Elements, und/oder eine zweite Spannungsdifferenz (zweiter Headroom) zwischen erstem Anschluss und zweiter Spannung so gewählt, dass erste Spannungsdifferenz und die zweite Spannungsdifferenz ungefähr gleich groß oder ungefähr an die Tastgerade angepasst sind und/oder ihr Verhältnis ungefähr in der Spanne zwischen eins und an die Tastgrade angepasster Wahl liegen.

Unter "ungefähr" wird dabei insbesondere eine Abweichung von genannter Ausgestaltung von weniger als 25%, insbesondere weniger als 15%, insbesondere der Hälfte der Summe der ersten und zweiten Spannungsdifferenz verstanden und/oder des Verhältnisses.

Eine an die Tastgrade angepasste Wahl liegt insbesondere dann vor, wenn die Anpassung eine an den minimalen und maximalen Tastgrad des ersten, des zweiten und/oder der Schaltelemente der mindestens einen Halbbrücke, insbesondere den unter den Schaltelementen größten minimalen und den unter den Schaltelementen kleinsten maximalen Tastgrad.

Die Anpassung an die Tastgrade erfolgt dabei insbesondere so, dass die Spannungsdifferenz von der höheren von erster und zweiter Spannung zur Spannungsdifferenz zur niedrigeren von erster und zweiter Spannung ein Verhältnis aufweisen, dass der Differenz aus dem Kehrwert des arithmetischen Mittels von kleinstem und größtem Tastgrad abzüglich 1 entspricht.

Im obigen Beispiel betrug das Verhältnis 1,222 und würde die Spanne von der symmetrischen Ausgestaltung zur an die Tastgrade angepassten Ausgestaltung von 1 bis 1,222 laufen und würde die Spanne der ungefähr symmetrischen Ausgestaltung bis zur ungefähr an den Tastgrad angepassten Ausgestaltung von 0,75 bis 1,53 laufen.

Besonders vorteilhaft ist es, die Halbbrücke als Tiefsetzsteller, Buck-Wandler, und/oder Class-D Verstärker auszugestalten. Dadurch lässt sich die Verlustleistung weiter reduzieren.

Mit Vorteil ist/wird parallel zum Eingang der, insbesondere bidirektionalen, Spannungsquelle mindestens ein Kondensator angeordnet. Dadurch lässt sich die Spannungsversorgung stabilisieren, was gerade bei dynamischem Betrieb der Halbbrücke von großer Bedeutung ist.

Mit besonderem Vorteil sind die Schaltelemente durch je mindestens einen Transistor, insbesondere BJT und/oder Feldeffekt-Transistor, wie insbesondere MOSFET, IGBT, GIT, HEMT und/oder JFET gebildet. Dadurch lassen sich hohe Dynamiken und geringe Verlustleistungen erreichen.

Bevorzugt ist die Spannungsquelle eingerichtet, die erste und zweite Spannung ausgehend von einer unipolaren Gleichspannungsquelle (DC-Link) zu erzeugen.

Mit Vorteil wird die mindestens eine Impedanzmessung als Vierpol-Messung durchgeführt und/oder ist die Vorrichtung/Anordnung zu Vierpol-Impedanzmessung ausgebildet.

Mit besonderem Vorteil wird/werden der durch die zur Erzeugung der ersten und/oder zweiten Spannung gebildete Vorrichtung, insbesondere die bidirektionale Spannungsquelle, die Zwischenkreiskondensatoren und/oder die Halbbrücke zur kurzeitigen Energiespeicherung genutzt. Dadurch lässt sich die Effizienz weiter erhöhen.

Anhand der nachfolgenden rein schematischen und nicht beschränkenden Figuren werden im Folgenden exemplarisch einige Aspekte der Erfindung erläutert, dabei zeigen:
- Fig. 1: eine Anordnung mit Spannungsversorgung, Halbbrücke und elektrochemischem Element aus dem Stand der Technik,
- Fig. 2: eine Veranschaulichung des wesentlichen Unterschiedes zwischen einer Anordnung nach Fig. 1 und der Erfindung und
- Fig. 3: sowie
- Fig. 4: vorteilhafte Ausgestaltungen und Anordnungen von Messleitungen bei Reihenschaltung mehrerer Zellen,
- Fig. 5: eine sehr schematische Darstellung einer möglichen Ausgestaltung einer erfindungsgemäßen Vorrichtung mit einer Mehrzahl erfindungsgemäßer Halbbrücken und
- Fig. 6: eine mögliche Ausgestaltung einer erfindungsgemäßen Vorrichtung mit einer Mehrzahl erfindungsgemäßer Halbbrücken.

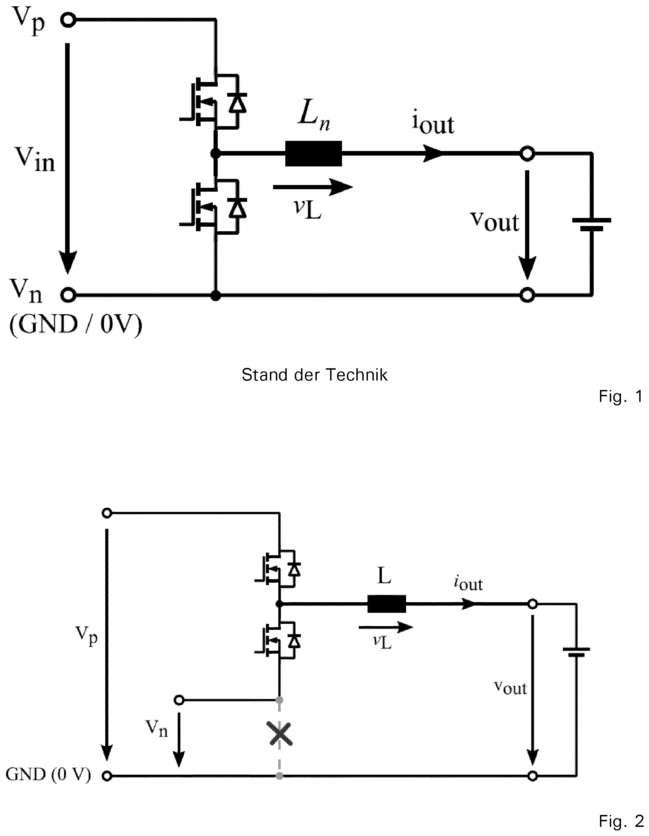

Fig. 1 zeigt eine Halbbrücke mit zwei MOSFETs, die mittels Vin zwischen Vn/GND und Vp gespeist wird. Das elektrochemische Element (rechts in der Darstellung) liegt mit einem seiner Pole auch auf GND. Durch Tastung der zwei MOSFETs wird ein veränderlicher Anregungsstrom iₒᵤₜ erzeugt.

Fig. 2 zeigt die Umgestaltung zu einer erfindungsgemäßen Vorrichtung, indem die direkte Kopplung von Vn und dem Pol des elektrochemischen Elements aufgehoben wird (angedeutet durch das Kreuz auf der gestrichelten Verbindung) und eine Spannung Vn ungleich null zwischen GND und Source des unteren MOSFETs geschaffen wird.

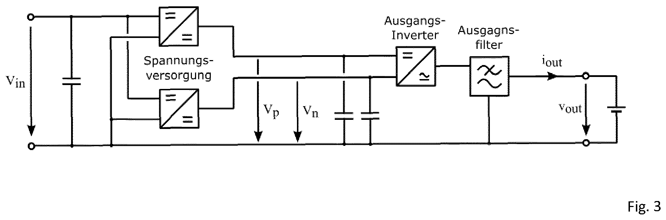

Fig. 3 zeigt eine mögliche Ausgestaltung einer erfindungsgemäßen Vorrichtung mit zwei DC/DC-Konvertern als Spannungsversorgung, die aus einer DC-Link-Gleichspannung (Vin) zwei Versorgungsspannungen (Vp, Vn) generiert, mit denen die Halbbrücke (Output inverter) gespeist wird. Zur Spannungsstabilisierung sind drei Kondensatoren angeordnet. Zur Glättung ist ein Ausgangs-Filter vorgesehen. Ganz rechts ist das elektrochemische Element gezeigt.

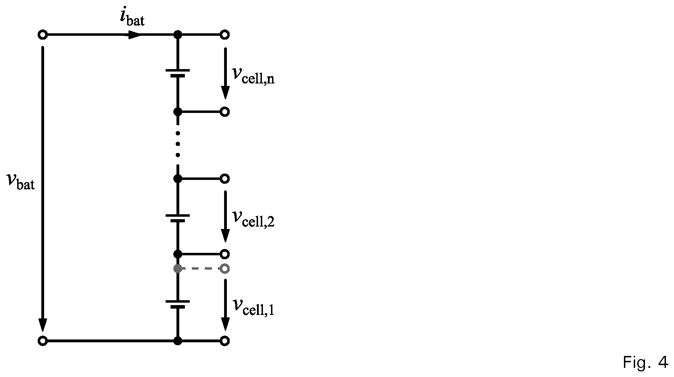

Fig. 4 zeigt Möglichkeiten zur Anordnung von Messleitern bei Reihenschaltung mehrerer Zellen. Diese Anordnung kann beispielsweise statt dem elektrochemischen Element in Figur 3 in diese Anordnung eingesetzt werden.

Optimalerweise werden pro Zelle zwei Messleitungen verwendet. Es ist aber mit geringen Abstrichen auch möglich, zwischen zwei Zellen nur eine Messleitung anzuordnen.

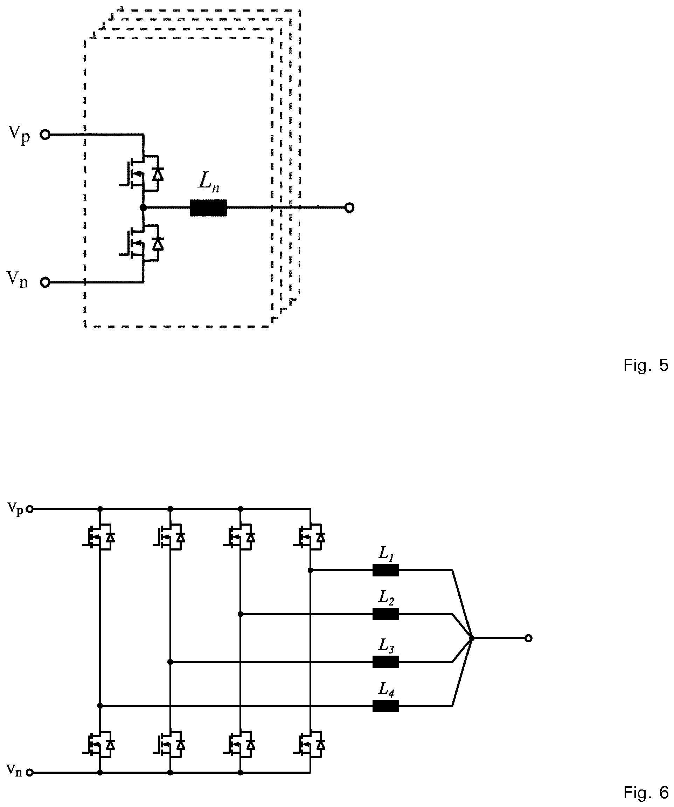

Fig. 5 zeigt eine sehr schematische Darstellung einer möglichen Ausgestaltung einer erfindungsgemäßen Vorrichtung mit einer Mehrzahl erfindungsgemäßer Halbbrücken, wobei der zweite Anschluss nicht dargestellt ist.

Fig. 6 zeigt die Anordnung aus Figur 5 in einer etwas weniger schematischen Darstellung. Zu erkennen ist die Parallelschaltung der erfindungsgemäßen Halbbrücken.

## Patentansprüche

1. Vorrichtung zur Anregung mindestens eines Stroms durch ein elektrochemisches Element,
wobei die Vorrichtung einen ersten Anschluss zum Anschluss eines ersten Pols des zu vermessenden Elements und einen zweiten Anschluss zum Anschluss eines zweiten Pols des zu vermessenden Elements aufweist,
wobei die Vorrichtung mindestens eine Halbbrücke mit zwei Schaltelementen aufweist, deren erstes Schaltelement zwischen einem ersten Versorgungsleiter und dem ersten Anschluss und deren zweites Schaltelement zwischen dem ersten Anschluss und einem zweiten Versorgungsleiter angeordnet ist, wobei die Vorrichtung eingerichtet ist, zwecks Anregung des mindestens einen Stroms die Schaltelemente der mindestens einen Halbbrücke über die Zeit verändert anzusteuern,
und wobei die Vorrichtung eine, insbesondere bidirektionale, Spannungsquelle aufweist, die eine erste Spannung ungleich null gegen den zweiten Anschluss auf dem ersten Versorgungsleiter und eine zweite, insbesondere umgekehrt gepolte, Spannung ungleich der ersten Spannung gegen den zweiten Anschluss auf dem zweiten Versorgungsleiter bereit stellt,
**dadurch gekennzeichnet, dass** die Zweite Spannung ebenfalls ungleich null gegen den zweiten Anschluss ist.

2. Vorrichtung nach Anspruch 1, wobei die Spannungsquelle eine symmetrische ist und/oder zwei DC/DC-Konverter aufweist, die insbesondere zur Speisung mit einer unipolaren Eingangsspannungsversorgung verbindbar und/oder verbunden sind.

3. Vorrichtung nach einem der vorstehenden Ansprüche, wobei zwischen erstem Versorgungsleiter und dem zweiten Anschluss und zwischen zweitem Versorgungsleiter und dem zweiten Anschluss jeweils mindestens ein Kondensator und/oder wobei zwischen Halbbrücke und erstem Anschluss und/oder zwischen zweitem und erstem Anschluss ein Filter und/oder eine Drossel angeordnet ist.

4. Vorrichtung nach einem der vorstehenden Ansprüche, wobei eine erste Spannungsdifferenz zwischen erster Spannung und erstem Anschluss und/oder eine zweite Spannungsdifferenz zwischen erstem Anschluss und zweiter Spannung so gewählt ist, dass erste Spannungsdifferenz und zweite Spannungsdifferenz ungefähr gleich groß oder ungefähr an die Tastgerade angepasst sind und/oder ihr Verhältnis ungefähr in der Spanne zwischen eins und an die Tastgrade angepasster Wahl liegen.

5. Vorrichtung nach einem der vorstehenden Ansprüche, wobei erste und zweite Spannung mit einer Abweichung von je maximal 25% der höheren der vorgenannten Spannungen symmetrisch um ein Potential eines Pols des elektrochemischen Elements und/oder die Spannung des elektrochemischen Elements angeordnet sind.

6. Vorrichtung nach einem der vorstehenden Ansprüche, wobei die Vorrichtung eingerichtet ist, die mindestens eine Halbbrücke als Class-D Verstärker zu schalten.

7. Vorrichtung nach einem der vorstehenden Ansprüche, wobei parallel zum Eingang der Spannungsquelle mindestens ein Kondensator angeordnet ist und/oder wobei die Schaltelemente durch je mindestens einen MOSFET, BJT, IGBT, GIT, HEMT und/oder JFET gebildet sind.

8. Vorrichtung nach einem der vorstehenden Ansprüche, wobei die Spannungsquelle eingerichtet ist die erste und zweite Spannung ausgehend von einer unipolaren Gleichspannungsquelle (DC-Link) zu erzeugen.

9. Vorrichtung zur Impedanzmessung aufweisend eine Vorrichtung nach einem der vorstehenden Ansprüche und eine Vorrichtung zur Impedanzmessung aufweisend einen ersten Messleiter und einen zweiten Messleiter zum Anschließen an ein elektrochemisches Element zur Messung der Impedanz bei durch das elektrochemische Element fließendem sich über die Zeit veränderndem Strom.

10. Anordnung bestehend aus einer Vorrichtung nach einem der vorstehenden Ansprüche und aus einem elektrochemischen Element, insbesondere aufweisend eine Mehrzahl in Reihe geschalteter Zellen, wobei das elektrochemische Element mit seinem ersten Pol mit dem ersten Anschluss und insbesondere auch erstem Messleiter und mit seinem zweiten Pol mit dem zweiten Anschluss und insbesondere auch zweitem Messleiter verbunden ist.

11. Verfahren zur Anregung mindestens eines Stroms durch ein elektrochemisches Element,
wobei die Anregung des mindestens eines Stroms mittels über die Zeit veränderter Ansteuerung mindestens zweier Schaltelemente mindestens einer Halbbrücke erfolgt,
**dadurch gekennzeichnet, dass**
die Spannungsversorgung der Halbbrücke gleichzeitig durch eine erste und eine zweite Spannung erfolgt die verschieden und beide ungleich der Potentiale beider Pole des elektrochemischen Elements sind.

12. Verfahren nach Anspruch 11, wobei mindestens eine Impedanzmessung als Vierpol-Messung durchgeführt wird.

13. Verfahren nach einem der vorstehenden Ansprüche 11 bis 12, wobei der durch die zur Erzeugung der ersten und/oder zweiten Spannung gebildete Vorrichtung und die Halbbrücke zur kurzeitigen Energiespeicherung genutzt werden.

14. Verwendung zweier Spannungen zur gleichzeitigen Speisung einer Halbbrücke zur Anregung mindestens eines Stroms durch ein elektrochemisches Element,
wobei Anregung des mindestens eines Stroms mittels über die Zeit veränderter Ansteuerung mindestens zweier Schaltelemente der Halbbrücke erfolgt,
**dadurch gekennzeichnet, dass**
die Spannungen verschieden und ungleich der Potentiale beider Pole des elektrochemischen Elements sind.

15. Verwendung nach Anspruch 14, wobei mehrere parallel geschaltete Halbbrücken zur Anregung des mindestens eines Stroms durch das elektrochemisches Element genutzt werden,
wobei Anregung des mindestens eines Stroms mittels über die Zeit veränderter Ansteuerung der mindestens zwei Schaltelemente je Halbbrücke der Mehrzahl erfolgt,
und jede der Halbbrücken mittels zweier Spannungen zur gleichzeitigen Speisung der jeweiligen Halbbrücke gespeist wird, wobei dies insbesondere durch insgesamt zwei Spannungsquellen realisiert wird, wobei die zwei Spannungen verschieden und ungleich des Potential eines Pols, insbesondere ungleich der Potentiale beider Pole, des elektrochemischen Elements sind.

## Claims

1. A device for generating at least one current through an electrochemical cell,
the device comprising a first terminal for connecting a first pole of the cell to be measured and a second terminal for connecting a second pole of the cell to be measured,
wherein the device comprises at least one half-bridge with two switching elements, the first switching element of which is arranged between a first supply conductor and the first terminal and the second switching element of which is arranged between the first terminal and a second supply conductor,
wherein the device is configured to drive the switching elements of the at least one half-bridge in a time-varying manner in order to induce the at least one current, and
wherein the device comprises a voltage source, in particular a bidirectional one, which provides a first voltage non-zero across the second terminal on the first supply conductor and a second voltage, in particular one of opposite polarity, non-zero relative to the first voltage across the second terminal on the second supply conductor,
**characterised in that** the second voltage is also non-zero across the second terminal.

2. A device according to claim 1, wherein the voltage source is a symmetrical power supply and/or comprises two DC/DC converters which are, in particular, connectable and/or connected to a unipolar input voltage supply.

3. A device according to one of the preceding claims, wherein at least one capacitor is arranged between the first supply conductor and the second terminal and between the second supply conductor and the second terminal, and/or wherein a filter and/or a choke is arranged between the half-bridge and the first terminal and/or between the second and first terminals.

4. A device according to one of the preceding claims, wherein a first voltage difference between the first voltage and the first terminal and/or a second voltage difference between the first terminal and the second voltage is selected such that the first voltage difference and the second voltage difference are approximately equal in magnitude or approximately adapted to the sampling line, and/or their ratio lies approximately within the range between one and a value adapted to the sampling line.

5. A device according to one of the preceding claims, wherein the first and second voltages are arranged symmetrically about a potential of a pole of the electrochemical cell and/or the voltage of the electrochemical cell, with a deviation of no more than 25 per cent of the higher of the aforementioned voltages.

6. A device according to one of the preceding claims, wherein the device is configured to switch the at least one half-bridge as a Class-D amplifier.

7. A device according to one of the preceding claims, wherein at least one capacitor is arranged in parallel with the input of the voltage source and/or wherein the switching elements are each formed by at least one MOSFET, BJT, IGBT, GIT, HEMT and/or JFET.

8. A device according to one of the preceding claims, wherein the voltage source is configured to generate the first and second voltages from a unipolar DC voltage source (DC link).

9. An impedance measurement device comprising a device according to any one of the preceding claims and an impedance measurement device comprising a first measuring lead and a second measuring lead for connection to an electrochemical cell for measuring the impedance when a current varying over time flows through the electrochemical cell.

10. An arrangement comprising a device according to any one of the preceding claims and an electrochemical element, in particular comprising a plurality of cells connected in series, wherein the electrochemical element is connected with its first pole to the first terminal and, in particular, also to the first measuring lead, and with its second pole to the second terminal and, in particular, also to the second measuring lead.

11. A method for generating at least one current through an electrochemical element,
wherein the generation of the at least one current is effected by means of a time-varying control of at least two switching elements of at least one half-bridge, **characterised in that** the half-bridge is supplied with power simultaneously by a first and a second voltage, which are different and both unequal to the potentials of both poles of the electrochemical element.

12. A method according to claim 11, wherein at least one impedance measurement is carried out as a four-pole measurement.

13. A method according to any one of the preceding claims 11 to 12, wherein the device formed to generate the first and/or second voltage and the half-bridge are used for short-term energy storage.

14. Use of two voltages to simultaneously supply a half-bridge for generating at least one current through an electrochemical cell, wherein the at least one current is induced by means of a time-varying control of at least two switching elements of the half-bridge,
**characterised in that** the voltages are different and unequal to the potentials of both poles of the electrochemical element.

15. Use according to claim 14, wherein a plurality of half-bridges connected in parallel are used to induce the at least one current through the electrochemical cell, wherein the at least one current is induced by means of a time-varying control of the at least two switching elements per half-bridge of the plurality, and each of the half-bridges is supplied by two voltages for the simultaneous supply of the respective half-bridge, this being realised in particular by a total of two voltage sources, wherein the two voltages are different and unequal to the potential of one pole, in particular unequal to the potentials of both poles, of the electrochemical element.

## Revendications

1. Dispositif permettant d'exciter au moins un courant à travers un élément électrochimique,
le dispositif comportant une première borne destinée à être connectée à un premier pôle de l'élément à mesurer et une seconde borne destinée à être connectée à un second pôle de l'élément à mesurer,
le dispositif comportant au moins un demi-pont comprenant deux éléments de commutation, dont le premier élément de commutation est disposé entre un premier conducteur d'alimentation et la première borne et dont le second élément de commutation est disposé entre la première borne et un second conducteur d'alimentation,
le dispositif étant agencé pour commander les éléments de commutation dudit au moins un demi-pont de manière variable dans le temps afin de générer ledit au moins un courant, et
le dispositif comportant une source de tension, notamment bidirectionnelle, qui fournit une première tension non nulle par rapport à la seconde borne sur le premier conducteur d'alimentation et une seconde tension, notamment de polarité inverse, différente de la première tension, par rapport à la seconde borne sur le seconde conducteur d'alimentation,
**caractérisé en ce que** la seconde tension est également différente de zéro par rapport à la seconde borne.

2. Dispositif selon la revendication 1, dans lequel la source de tension est un symétriseur et/ou comprend deux convertisseurs CC/CC qui peuvent notamment être raccordés et/ou sont raccordés à une alimentation en tension d'entrée unipolaire.

3. Dispositif selon l'une des revendications précédentes, dans lequel au moins un condensateur est disposé respectivement entre le premier conducteur d'alimentation et la seconde borne et entre le second conducteur d'alimentation et la seconde borne, et/ou dans lequel un filtre et/ou une bobine est disposé(e) entre le demi-pont et la première borne et/ou entre la seconde borne et la première borne.

4. Dispositif selon l'une des revendications précédentes, dans lequel une première différence de tension entre la première tension et la première borne et/ou une seconde différence de tension entre la première borne et la seconde tension est choisie de telle sorte que la première différence de tension et la seconde différence de tension soient approximativement égales ou approximativement adaptées à la droite de balayage et/ou que leur rapport se situe approximativement dans la plage comprise entre un et une valeur choisie adaptée à la droite de balayage.

5. Dispositif selon l'une des revendications précédentes, dans lequel les première et seconde tensions sont disposées symétriquement autour d'un potentiel d'un pôle de l'élément électrochimique et/ou de la tension de l'élément électrochimique, avec un écart maximal de 25 % chacune par rapport à la plus élevée des tensions susmentionnées.

6. Dispositif selon l'une des revendications précédentes, dans lequel le dispositif est agencé pour commuter ledit au moins un demi-pont en tant qu'amplificateur de classe D.

7. Dispositif selon l'une des revendications précédentes, dans lequel au moins un condensateur est disposé en parallèle à l'entrée de la source de tension et/ou dans lequel les éléments de commutation sont constitués chacun d'au moins un MOSFET, un BJT, un IGBT, un GIT, un HEMT et/ou un JFET.

8. Dispositif selon l'une des revendications précédentes, dans lequel la source de tension est agencée pour générer les première et seconde tensions à partir d'une source de tension continue unipolaire (lien CC).

9. Dispositif de mesure d'impédance comprenant un dispositif selon l'une des revendications précédentes et un dispositif de mesure d'impédance comprenant un premier conducteur de mesure et un second conducteur de mesure destinés à être raccordés à un élément électrochimique pour mesurer l'impédance lorsqu'un courant variant dans le temps circule à travers l'élément électrochimique.

10. Ensemble composé d'un dispositif selon l'une des revendications précédentes et d'un élément électrochimique, comportant notamment une pluralité de cellules montées en série, l'élément électrochimique étant relié par son premier pôle à la première borne et notamment également au premier conducteur de mesure, et par son seconde pôle à la seconde borne et notamment également au second conducteur de mesure.

11. Procédé pour exciter au moins un courant à travers un élément électrochimique, l'excitation dudit au moins un courant s'effectuant au moyen d'une commande variant dans le temps d'au moins deux éléments de commutation d'au moins un demi-pont, **caractérisé en ce que** l'alimentation en tension du demi-pont s'effectue simultanément par une première et une seconde tensions qui sont différentes et toutes deux inégales par rapport aux potentiels des deux pôles de l'élément électrochimique.

12. Procédé selon la revendication 11, dans lequel au moins une mesure d'impédance est effectuée sous forme de mesure à quatre pôles.

13. Procédé selon l'une des revendications 11 à 12 ci-dessus, dans lequel le dispositif formé pour générer la première et/ou la seconde tension et le demi-pont sont utilisés pour le stockage temporaire d'énergie.

14. Utilisation de deux tensions pour alimenter simultanément un demi-pont afin de susciter au moins un courant à travers un élément électrochimique, la suscitation dudit au moins un courant s'effectuant au moyen d'une commande variant dans le temps d'au moins deux éléments de commutation du demi-pont,
**caractérisée en ce que** les tensions sont différentes et inégales par rapport aux potentiels des deux pôles de l'élément électrochimique.

15. Utilisation selon la revendication 14, dans laquelle plusieurs demi-ponts montés en parallèle sont utilisés pour exciter ledit au moins un courant à travers l'élément électrochimique, l'excitation dudit au moins un courant s'effectuant au moyen d'une commande variant dans le temps desdits au moins deux éléments de commutation par demi-pont de ladite pluralité, et chacun des demi-ponts étant alimenté au moyen de deux tensions destinées à alimenter simultanément le demi-pont concerné, ce qui est notamment réalisé à l'aide de deux sources de tension au total, les deux tensions étant différentes et inégales par rapport au potentiel d'un pôle, en particulier inégales par rapport aux potentiels des deux pôles, de l'élément électrochimique.
